Europäisches Patentamt

European Patent Office

Office européen des brevets

(11) Publication number: **0 023 118**
**B1**

# EUROPEAN PATENT SPECIFICATION

(45) Date of publication of patent specification: **06.11.85**

(21) Application number: **80302374.6**

(22) Date of filing: **15.07.80**

(51) Int. Cl.⁴: **H 03 K 19/092,**
H 03 K 19/091, H 01 L 27/02,
H 03 K 19/088

(54) Integrated semiconductor devices.

(30) Priority: **19.07.79 JP 100104/79**

(43) Date of publication of application:
**28.01.81 Bulletin 81/04**

(45) Publication of the grant of the patent:
**06.11.85 Bulletin 85/45**

(84) Designated Contracting States:
**DE FR GB NL**

(56) References cited:
**DE-B-1 766 488**

**IBM TECHNICAL DISCLOSURE BULLETIN, vol. 19, no. 10, March 1977, New York, R. NIJHUIS et al. "Semiconductor Chip Interface Circuit", pages 3741 to 3742**
**IEEE JOURNAL OF SOLID-STATE CIRCUITS, vol. SC-13, no. 5, October 1978, New York, O. TOMISAWA et al. "A 920 Gate DSA MOS Masterslice", pages 536 to 541**

(73) Proprietor: **FUJITSU LIMITED**
**1015, Kamikodanaka Nakahara-ku**
**Kawasaki-shi Kanagawa 211 (JP)**

(72) Inventor: **Ohba, Osamu**
**536-5-2-302 Ohmai Inagi-shi**
**Tokyo, 192-02 (JP)**
Inventor: **Yoshida, Makoto**
**5-12-C-203, Tsutsujigaoka Midori-ku**
**Yokohama-shi Kanagawa 227 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

(56) References cited:
**REVIEW OF THE ELECTRICAL COMMUNICATION LABORATORIES, vol. 26, no. 9-10, September-October 1978, Tokyo, K. WADA et al. "Master-slice layout design for emitter coupled logic LST", pages 1355 to 1366**

Courier Press, Leamington Spa, England.

**Description**

This invention relates to integrated semiconductor devices.

Generally, in an integrated semiconductor device a functional circuit which is responsible for providing the various functions which the device can perform is disposed in the central area of the chip of the device and an interface circuit responsible for signal transfer between the functional circuit and circuits external to the chip is disposed in a peripheral area of the chip.

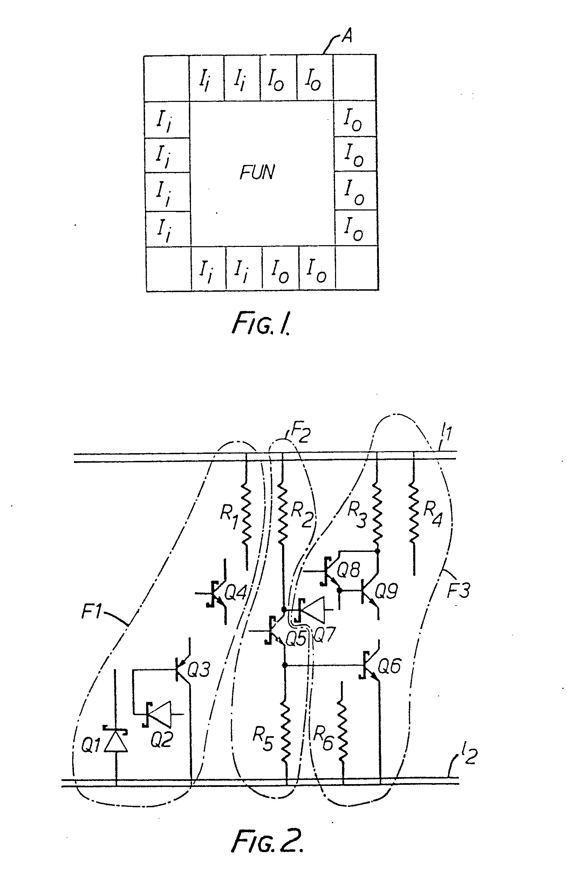

Figure 1 of the accompanying drawings illustrates schematically an integrated semiconductor device as previously provided.

In Figure 1, A indicates a chip of an integrated semiconductor device, for example, a large scale integrated circuit (LSI). In the central area of the chip, functional circuit FUN is arranged, whilst interface circuits $I_i$, $I_o$ are arranged in peripheral areas. The interface circuits $I_i$, $I_o$ and the functional circuit FUN are connected.

In Figure 1, $I_i$ is an input interface circuit which transfers a signal sent from a circuit external to the chip to the functional circuit FUN, whilst $I_o$ is an output interface circuit which transfers a signal from the functional circuit FUN to a circuit external of the chip.

In this existing semiconductor device the interface circuits are fixedly arranged and are each structured so as to provide either input or output functions exclusively. For example, input interface circuits are all fixed to the left side of the chip A in Figure 1, whilst the output interface circuits are all at the right side.

In such an integrated semiconductor device, since the input and output interface circuits are fixedly arranged and since only specified numbers of each type of circuit are available only at specified areas, locations of input/output terminals, the number of such terminals and the ratio of the number of input/output terminals are subject to limitations which reduce the degree of freedom available. Moreover, when considering such a chip from the standpoint of customers who will design systems incorporating such integrated semiconductor devices, difficulties of designing a printed circuit board (PCB), which may depend on the combination of device circuits and peripheral circuits offered by a relevant device, is a very important problem, and various factors such as the limited number of input/output terminals of the device and the limited arrangement of such terminals may add extra difficulty in the design stage of the PCB and system.

US—A—3 573 488 discloses an LSI array of standard cells. The standard cell includes a current mode switching transistor pair, a pair of fan-in expander transistors, a further transistor useful either as an output emitter-follower or as another fan-in transistor and a $V_{ref}$ deriving circuit which includes some resistors and another pair of transistors. Committed and uncommitted connecting points are provided for the cell. By appropriate use of uncommitted connection points a standard cell can function as a logic gate, or as an input interface circuit, for sending signals to such a logic gate, or as an output interface circuit, for receiving signals from such a logic gate. In its interface circuit configurations the cell has an input stage and an output stage which accommodate different voltage swings and can afford different threshold voltages.

According to the present invention there is provided an integrated semiconductor device including a semiconductor chip, having a functional circuit disposed in a central area of the chip, and an input interface circuit, for transferring a signal sent from a circuit external of the device to the functional circuit, and an output interface circuit, for transferring a signal sent from the functional circuit to a circuit external of the device, the input interface circuit and the output interface circuit disposed in a peripheral area of the chip, each comprising an input stage and an output stage for an interface circuit, respective such stages of the input and output interface circuits having similar functions comprising the same kind and number of circuit elements as one another, the circuit elements being selectively connected to one another in the stages to form either the input interface circuit or the output interface circuit, as appropriate, and to provide respective different threshold voltages for signals incoming to those respective circuits, characterised in that the input interface circuit and the output interface circuit are transistor-transistor logic circuits and each further comprises an intermediate amplifier stage, respective such stages of the input and output interface circuits having the same kind and number of circuit elements as one another, in that in each said interface circuit

the input stage includes a plurality of active circuit elements of different kinds,

the intermediate amplifying stage has a first transistor, and

the output stage has a second transistor the base of which is connected to the emitter of the first transistor, and in that

one or more active circuit elements of the said plurality of active elements of the input stage are selectively connected to the base of the first transistor in respective different manners in the input and output interface circuits thereby to provide the respective different threshold voltages for signals incoming to those respective circuits.

An integrated semiconductor device embodying this invention can provide interface circuits which can be modified in circuit structure to adapt to a variety of input and output conditions, arranged in a peripheral area of the chip.

An integrated semiconductor device embodying this invention is such that input and output interface circuits can be arranged at desired locations around the peripheral area of the chip of the device.

An integrated semiconductor device embodying this invention is such that input interface circuits having various threshold values can be located at desired locations around the peripheral area of the chip.

Reference is made, by way of example, to the accompanying drawings, in which:—

Figure 1, as mentioned above, illustrates schematically an integrated semiconductor device as previously provided;

Figure 2 illustrates schematically an interface circuit in a device embodying this invention before wiring connections are established;

Figure 3 is a schematic diagram of an input interface circuit in an integrated semiconductor device embodying this invention;

Figure 4 is a schematic diagram of an input interface circuit in an integrated semiconductor device embodying this invention;

Figure 5 is a schematic diagram of an input interface circuit in an integrated semiconductor device embodying this invention;

Figure 6 is a schematic diagram of an output interface circuit in an integrated semiconductor device embodying this invention;

Figure 7 is a schematic diagram of a logical input interface circuit in an integrated semi-conductor device embodying this invention;

Figure 8 is a schematic diagram of a logical input interface circuit of an integrated semi-conductor device embodying this invention;

Figure 9 is a schematic diagram of a logical output interface circuit of an integrated semi-conductor device embodying this invention;

Figure 10 is a schematic diagram of a logical output interface circuit of an integrated semi-conductor device embodying this invention;

Figure 11 is a block diagram indicating an interface circuit and bonding pad arrangement of an integrated semiconductor device embodying this invention;

Figures 12 to 16 are respective block diagrams indicating modifications in which connections between the interface circuits and bonding pads of Figure 11 are altered; and

Figure 17 illustrates schematically an integrated semi-conductor device embodying this invention.

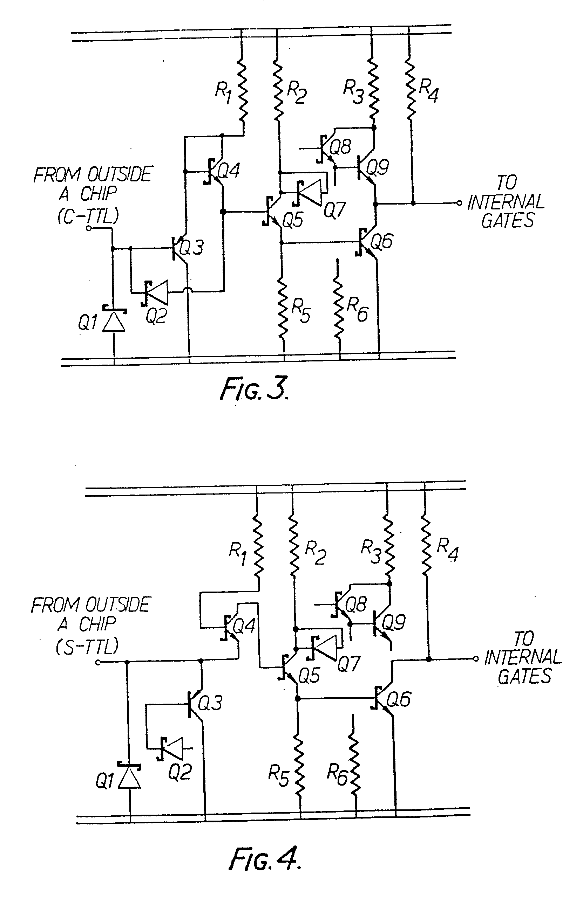

Figure 2 shows an interface circuit of a device embodying this invention. In Figure 2, $I_1$ is a power line; $I_2$ is a ground line; $F_1$ is an input stage of the circuit; $F_2$ is an intermediate amplifier stage of the circuit; $F_3$ is an output stage of the circuit. $R_1$ to $R_6$ are resistors belonging to these circuits; $Q_3$ to $Q_6$, $Q_8$, $Q_9$ are transistors; $Q_1$, $Q_2$, $Q_7$ are diodes. Transistors and diodes bearing the symbol $\int$ are Schottky clamp type transistors and Schottky type diodes respectively. When these resistors, transistors and diodes are used in the ways indicated in the following table (i.e. when elements indicated by their symbols are actively employed in the circuits) and wiring connections are established as shown in Figure 3 to Figure 10, various kinds of input levels and output profiles can be attained, for the interface circuit.

| Elements | $Q_1$ | $Q_2$ | $Q_3$ | $Q_4$ | $Q_5$ | $Q_6$ | $Q_7$ | $Q_8$ | $Q_9$ | $R_1$ | $R_2$ | $R_3$ | $R_4$ | $R_5$ | $R_6$ | Figs. |
|---|---|---|---|---|---|---|---|---|---|---|---|---|---|---|---|---|
| Variations 1 | O | O | O | O | O | O | | | | O | O | | O | O | | 3 |
| 2 | O | | | O | O | O | | | | O | O | | O | O | | 4 |
| 3 | O | O | | | O | O | | | | O | O | | O | O | | 5 |
| 4 | | | | O | O | O | O | O | O | O | O | O | | O | O | 6 |
| 5 | O | | O | O | O | O | | | | O | O | | O | O | | 7 |
| 6 | O | | O | O | O | O | | | | O | O | | O | O | | 8 |
| 7 | O | | O | O | O | O | O | O | O | O | O | O | | O | O | 9 |
| 8 | O | O | O | O | O | O | O | O | O | O | O | O | | O | O | 10 |

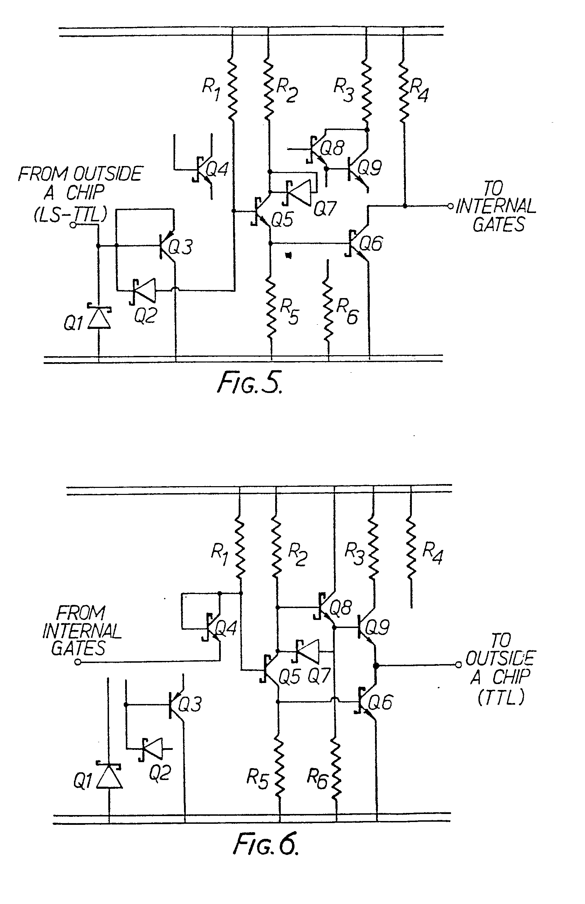

The circuit of Figure 3, which corresponds to variation 1 in the table, employs an input threshold voltage $V_{th}$ of 1.5V, and can receive an input of conventional TTL (hereinafter referred to as C-TTL) level from an external circuit and realise signal transmission to the internal (function) circuit of a large scale integrated circuit (LSI) on the same substrate as the interface circuit. The circuit of Figure 4, corresponding to variation 2, employs an input threshold voltage $V_{th}$ of 1.3V, just suitable for receiving an input of Schottky TTL (S-TTL) level and can realise signal transmission to the internal circuit of an LSI on the same substrate as the interface circuit. Further, the circuit of Fig. 5 employs an input threshold voltage $V_{th}$ of 1.2V, suitable for receiving an input of LS-TTL level and can realise signal transmission to the internal circuit of an LSI on the same substrate as the interface circuit.

The circuit operation of Figure 3 will now be explained. When the input terminal is at an L (low) level, the transistor $Q_3$ comes ON. Thereby, since the base current of the transistor $Q_5$ is cut off and $Q_5$ turns OFF, followed by $Q_6$ becoming OFF, setting the output terminal to H (high) level. In addition, when the input terminal is at an H (high) level, the transistor $Q_3$ becomes OFF and base current for $Q_5$ is supplied via the C-B (collector-base) shorted $Q_4$ and thereby $Q_5$ turns ON. As a result $Q_6$ turns ON, setting the output terminal to L level. The reason why the threshold voltage is 1.5V will be explained below. $V_{BE}$ (base-emitter voltage) of transistor $Q_6$ in the output stage is approx. 0.8V, $V_{BE}$ of transistor $Q_5$ in the amplifier stage is approx. 0.7V, $V_{BE}$ of the transistor $Q_4$ in the input stage is approx. 0.7V. Therefore whether the base current is supplied to the transistors $Q_5$ and $Q_6$ via the route Power supply $(I_1)$—Resistor $R_1$—$Q_4$ or not is determined by the fact that the sum of $V_{BE} \doteq 0.7V$ of the transistor $Q_3$ and the input voltage $V_x$ applied on the input terminal is 2.2V or higher or lower. For this reason, the threshold voltage becomes equal to $V_x = 2.2 - 0.7 = 1.5V$. The threshold voltages of the interface circuits illustrated in the other schematic diagrams of Figures 3 to 10 are determined in the same way.

The circuit of Figure 6, which corresponds to variation 4 in the table, has an input threshold voltage $V_{th}$ of 0.8V and transfers an input from an internal circuit of the LSI on which the circuit is provided to a circuit external of the LSI.

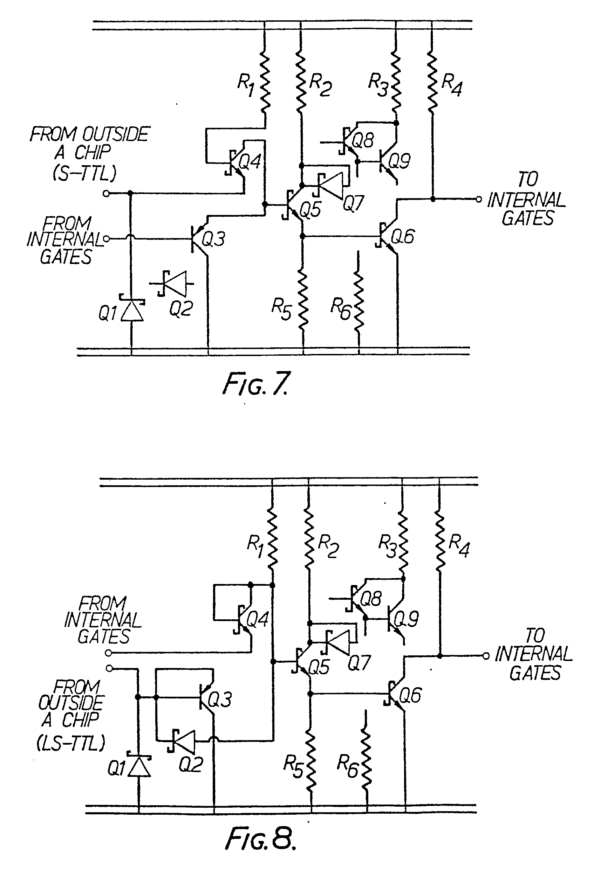

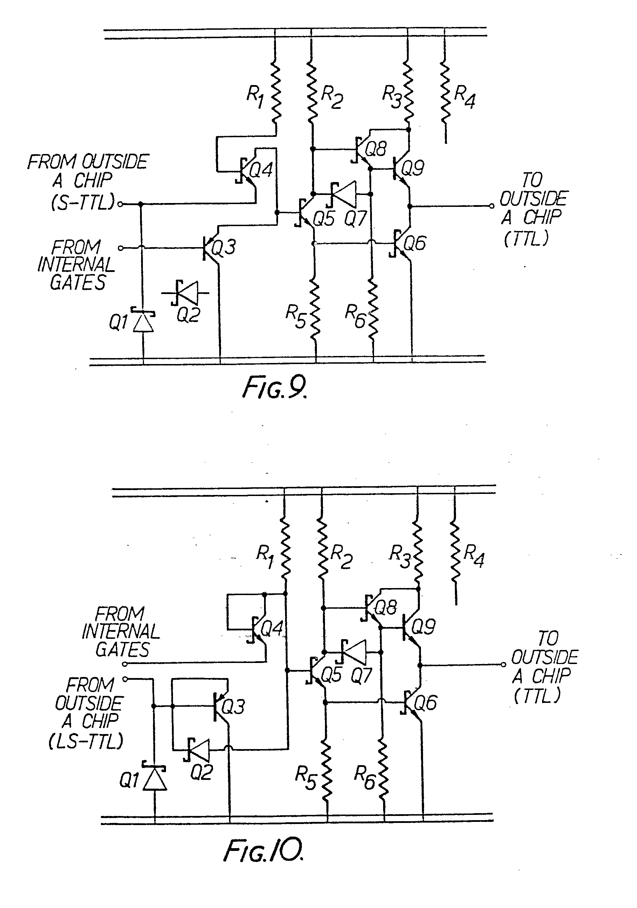

The circuit of Figure 7, corresponding to variation 5 of the table, has a couple of inputs respectively for an input from an external S-TTL circuit with an input threshold voltage $V_{th}$ of 1.3V, and for an input from an LSI internal circuit with $V_{th}$ of 0.8V and transfers input signals to the internal circuit of LSI. The circuit of Figure 8, corresponding to variation 6, has a couple of inputs respectively for an input from an LSI internal circuit with $V_{th}$ of 0.8V, and from an external LS-TTL circuit with $V_{th}$ of 1.2V, and transfers the input signals to the LSI internal circuit. The circuit of Fig. 9, corresponding to variation 7, has a couple of inputs, one for inputs from an external S-TTL circuit with $V_{th}$ of 1.3V and one for inputs from LSI internal circuit with $V_{th}$ of 0.8V, and transfers the input signals to the LSI external circuit. The circuit of Figure 10, corresponding to variation 8, has a couple of inputs, one for inputs from LSI internal circuit with $V_{th}$ of 0.8V, and one for inputs from an LS-TTL external circuit with $V_{th}$ of 1.2V, and transfers the input signals to an LSI (for example) external circuit. In the case of interface circuits of the two inputs type, when the inputs are H, H level, the output is L. In every other case the output is H level. Namely, these circuits operate as NAND gates.

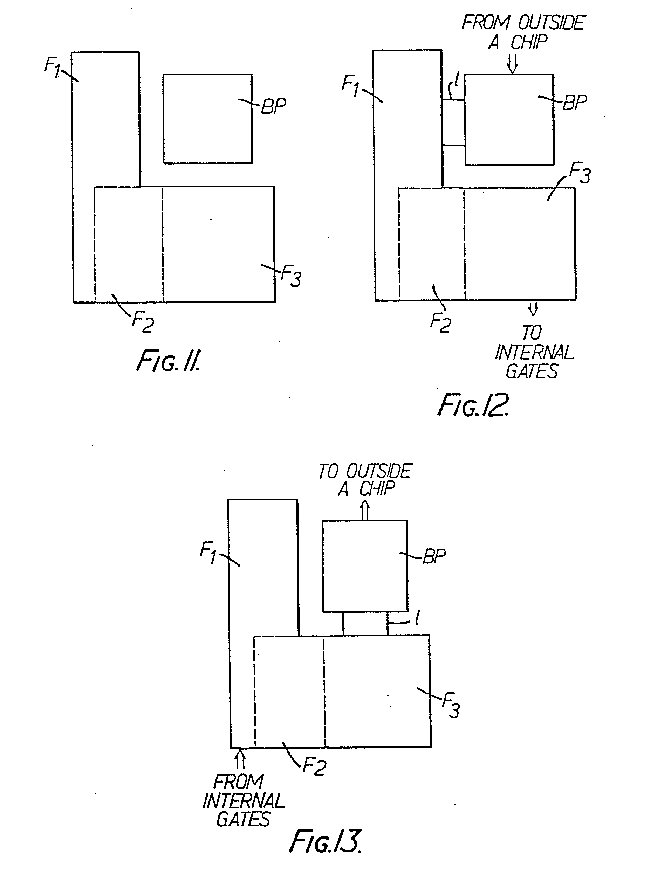

Figure 11 shows an interface circuit and bonding pad layout of an integrated semiconductor device embodying this invention.

In this Figure, $F_1$ is the input stage of Figure 2, $F_2$ is the intermediate amplifying stage, $F_3$ is the output stage, BP is a bonding pad.

As is apparent from the Figure, the input stage $F_1$, the intermediate amplifying stage $F_2$ and the output stage $F_3$ are arranged in the shape of the character "L", and the bonding pad BP is located inside the arms of the L-shape layout.

As shown in Figure 12, such a layout can be very convenient when the above circuits function as input interface circuits as shown in Figure 3, 4 and 5, by connecting the bonding pad BP and the input stage $F_1$ with wire lead $l$, such as aluminium lead etc. Namely, a signal coming to the bonding pad BP from outside the chip is transferred to an internal gate from the output stage.

On the other hand, as shown in Figure 13, the layout is convenient for bonding pad BP and output stage $F_3$ to function in an output interface circuit as shown in Figure 6 by connecting them with lead $l$. Namely a signal sent from an internal gate of the LSI device passes through input stage $F_1$, intermediate amplifying stage $F_2$, output stage $F_3$ and is transferred to the outside of the chip from the bonding pad BP.

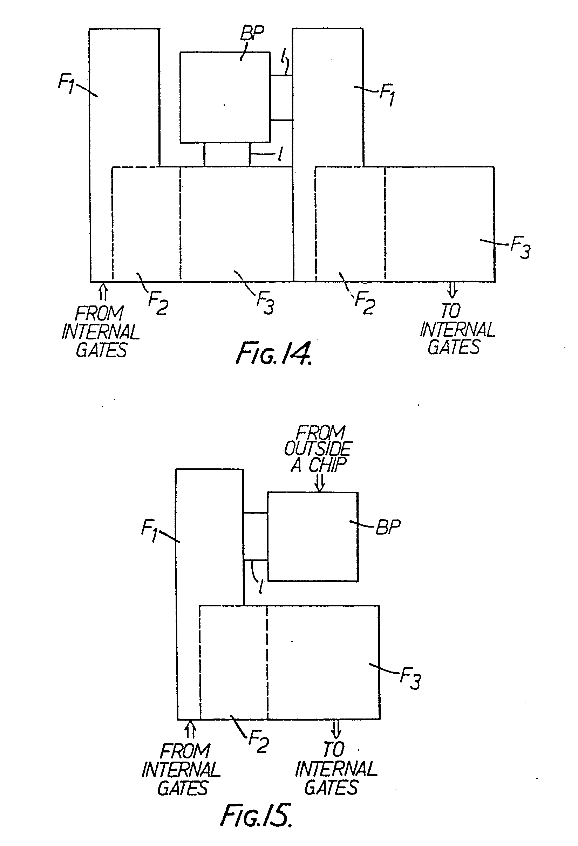

Moreover, as illustrated in Figure 14, following functions can be attained by using a couple of interface circuits $I_1$, $I_2$ adjacent to one another on the chip of the LSI device.

Namely, interface circuit $I_1$ is structured as an output interface and interface circuit $I_2$ as an input interface circuit. In addition, the output stage $F_3$ of the interface circuit $I_1$ and the bonding pad BP, and this bonding pad BP and the input stage $F_1$ of the interface circuit $I_2$ are respectively connected by the wire lead $l$. Thereby, the signal sent from an internal gate of the LSI is transferred to a circuit external of the chip of the LSI from the bonding pad BP via the input stage $F_1$ of the interface circuit $I_1$, intermediate amplifying stage $F_2$ and output stage $F_3$, and simultaneously transferred again to an internal gate of the LSI via the input stage $F_1$ of the interface circuit $I_2$, intermediate amplifying stage $F_2$ and output stage $F_3$.

Moreover, as shown in Figure 15, interface circuits structured as in Figure 7 or Figure 8 can be provided with bonding pad BP and input stage $F_1$ connected by wire lead $l$. Thereby, the result of a logical operation between an input signal transferred via the bonding pad BP from a circuit external of the chip of the LSI and the signal sent from an internal circuit of the LSI is transferred to an internal circuit of the LSI.

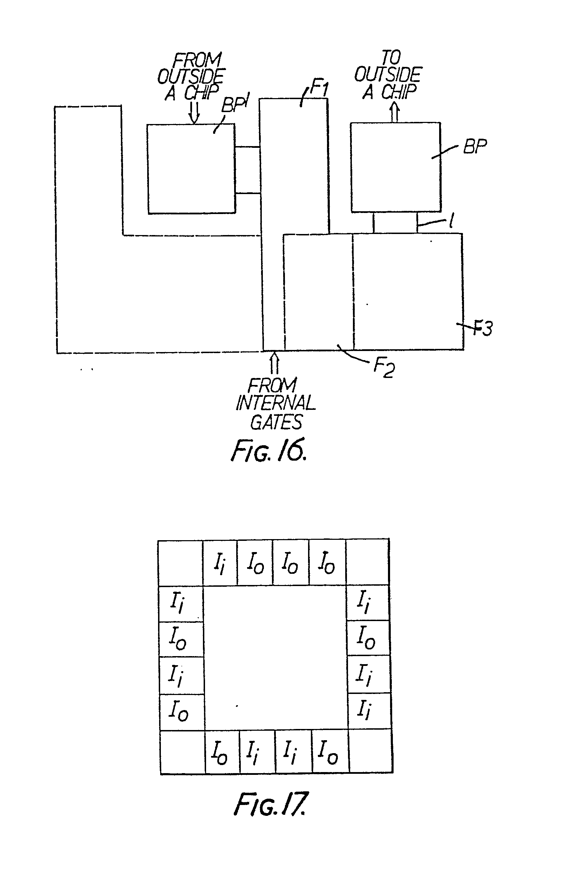

Then, as shown in Figure 16, an interface circuit structured as in Figure 9 or Figure 10 can be provided; bonding pad BP' of an adjacent interface circuit and its input stage $F_1$, and a bonding pad BP and the output stage $F_3$ of another interface circuit are respectively connected by wire lead $l$.

Thereby, the result of logical operation between a signal sent from a circuit external of the chip of the LSI and a signal sent from an internal circuit of the LSI is transferred (to a circuit external of the chip).

According to this invention, as explained above, input interface circuits and output interface circuits are not arranged fixedly as in the case of existing interface circuits as shown in Figure 1.

Figure 17 illustrates schematically one possible desired layout which can be adopted by wiring peripheral areas of an LSI device chip in accordance with an embodiment of this invention.

## Claims

1. An integrated semiconductor device including a semiconductor chip, having a functional circuit (FUN) disposed in a central area of the chip, and an input interface circuit ($I_i$), for transferring a signal sent from a circuit external of the device to the functional circuit (FUN), and an output interface circuit ($I_o$), for transferring a signal sent from the functional circuit (FUN) to a circuit external of the device, the input interface circuit ($I_i$) and the output interface circuit ($I_o$) disposed in a peripheral area of the chip, each comprising an input stage ($F_1$) and an output stage ($F_3$) for an interface circuit, respective such stages ($F_1$, $F_3$) of the input and output interface circuits having similar functions comprising the same kind and number of circuit elements as one another, the circuit elements being selectively connected to one another in the stages to form either the input interface circuit ($I_i$) or the output interface circuit ($I_o$), as appropriate, and to provide respective different threshold voltages for signals incoming to those respective circuits, characterised in that

the input interface circuit ($I_i$) and the output interface circuit ($I_o$) are transistor-transistor logic circuits and each further comprises an intermediate amplifier stage ($F_2$), respective such stages ($F_2$) of the input and output interface circuits having the same kind and number of circuit elements as one another, in that in each said interface circuit

the input stage ($F_1$) includes a plurality of active circuit elements ($Q_1$ to $Q_4$) of different kinds,

the intermediate amplifying stage ($F_2$) has a first transistor ($Q_5$), and

the output stage ($F_3$) has a second transistor ($Q_6$) the base of which is connected to the emitter of the first transistor ($Q_5$), and in that

one or more active circuit elements of the said plurality of active elements of the input stage are selectively connected to the base of the first transistor ($Q_5$) in respective different manners in the input and output interface circuits thereby to provide the respective different threshold voltages for signals incoming to those respective circuits.

2. A device as claimed in claim 1, wherein the intermediate amplifier stages ($F_2$) of the input and output interface circuits ($I_i$, $I_o$) each comprise the said first transistor ($Q_5$) with first ($R_2$) and second ($R_5$) resistors respectively connecting the collector of the first transistor to a power supply line ($I_1$) of the device and the emitter of the first transistor to a ground line ($I_2$) of the device, and wherein the input stages ($F_1$) of input and output interface circuits ($I_i$, $I_o$) each comprise a resistor ($R_1$) connected to the power supply line ($I_1$) of the device.

3. A device as claimed in claim 1 or 2, wherein the circuit elements in each said interface circuit are capable of connection to provide any of a plurality of different such threshold voltages appropriate respectively for incoming signals from conventional TTL circuitry, Schottky TTL circuitry, large scale TTL circuitry external of the device, and a large scale integration functional circuit of the device.

4. A device as claimed in claim 1 or 2, wherein each of the input and output interface circuits ($I_i$, $I_o$) is arranged in a generally L-shaped pattern, and a bonding pad (BP) is disposed between the arms of the L-shaped pattern.

5. A device as claimed in claim 4, wherein in each of the input and output interface circuits ($I_i$, $I_o$) the input stage ($F_1$) is located substantially in one arm of the L-shaped pattern, the output stage ($F_3$) is located substantially in the other arm of the L-shaped pattern, and the intermediate amplifier stage ($F_2$) is located substantially at the junction of the two arms.

6. A device as claimed in any preceding claim, wherein the input stages ($F_1$) of the input and output interface circuits ($I_i$, $I_o$) each comprise the following circuit elements:—

a resistor ($R_1$) connected at one end to a power supply line ($I_1$) of the device,

a first Schottky diode (Q1) connected at one end to a ground line ($I_2$) of the device,

a Schottky clamp type transistor (Q4),

a transistor (Q3) having its collector connected to the ground line ($I_2$) of the device, and

a second Schottky diode (Q2) connected at one end to the base of the transistor (Q3);

wherein the intermediate amplifier stages ($F_2$) of the input and output interface circuits ($I_i$, $I_o$) each comprises the following circuit elements:—

a first resistor ($R_2$) connected at one end to the power supply line ($I_1$) of the device,

a Schottky clamp type transistor (Q5), being the said first transistor of claim 1, having its collector connected to the other end of the first resistor ($R_2$) of the intermediate amplifier stage, and

a second resistor ($R_5$) connected at one end to the emitter of the Schottky clamp type transistor (Q5) of the intermediate amplifier stage, and connected at its other end to the ground line ($I_2$), and

wherein the output stages ($F_3$) of the input and output interface circuits ($I_i$, $I_o$) each comprise the following circuit elements:—

a first resistor ($R_4$) connected at one end to the power supply line ($I_1$),

a second resistor ($R_6$) connected at one end to the ground line ($I_2$),

a third resistor ($R_3$) connected at one end to the power supply line ($I_1$),

a first Schottky clamp type transistor (Q8) having its collector connected to the other end of the third resistor ($R_3$) of the output stage,

a transistor (Q9) having its collector connected to the other end of the third resistor ($R_3$) of the

output stage and its base connected to the emitter of the first Schottky clamp type transistor (Q8) of the output stage,

a Schottky diode (Q7) connected at one end to the other end of the first resistor (R$_2$) of the intermediate amplifier stage, and

a second Schottky clamp type transistor (Q6) being the said second transistor of claim 1, having its base connected to the one end of the second resistor (R$_5$) of the intermediate amplifier stage, and its emitter connected to the ground line (I$_2$).

## Patentansprüche

1. Integrierte Halbleitervorrichtung, mit einem Halbleiterchip, das eine funktionale Schaltung (FUN) hat, die in einem zentralen Bereich des Chip angeordnet ist, und mit einer Eingangsschnittstellenschaltung (I$_i$), zur Übertragung eines Signals, welches von einer Schaltung außerhalb der Vorrichtung zu der funktionalen Schaltung (FUN) gesendet wird, und einer Ausgans-Schnittstellenschaltung (I$_o$) zur Übertragung eines Signals, welches von der funktionalen Schaltung (FUN) zu einer Schaltung außerhalb der vorrichtung gesendet wird, bei welcher die Eingangsschnittstellenschaltung (I$_i$) und die Ausgangsschnittstellenschaltung (I$_o$) in einem peripheren Bereich des Chip angeordnet sind und jeweils eine Eingangsstufe (F$_1$) und eine Ausgangsstufe (F$_3$) für eine Schnittstellenschaltung umfassen, wobei solche entsprechenden Stufen (F$_1$, F$_3$) der Eingangs- und Ausgangsschnittstellenschaltungen ähnliche Funktionen haben und jeweils dieselbe Art und Anzahl von Schaltungselementen umfassen, die selektiv miteinander in den Stufen verbunden sind, um entweder die Eingangsschnittstellenschaltung (I$_i$) oder die Ausgangsschnittstellenschaltung (I$_o$) zu bilden, wie es geeignet ist, und um jeweils verschiedene Schwellschwertspannungen für Signale zu liefern, welche bei den jeweiligen Schaltungen ankommen, dadurch gekennzeichnet, daß

die Eingangsschnittstellenschaltung (I$_i$) und die Ausgangsschnittstellenschaltung (I$_o$) Transistor-Transistor-Logik-Schaltungen sind und jeweils ferner eine Zwischenverstärkerstufe (F$_2$) umfassen, wobei solche entsprechenden Stufen (F$_2$) der Eingangs- und Ausgangsschnittstellenschaltungen jeweils dieselbe Art und Anzahl von Schaltungselementen umfassen, und daß

die Eingangsstufe (F$_1$) in jeder der genannten Schnittstellenschaltungen eine Anzahl von aktiven Schaltungselementen (Q$_1$ bis Q$_4$) von verschiedenen Arten umfaßt,

die Zwischenverstärkerstufe (F$_2$) einen ersten Transistor (Q$_5$) und

die Ausgangsstufe (F$_3$) einen zweiten Transistor (Q$_6$) hat, dessen Basis mit dem Emitter des ersten Transistors (Q$_5$) verbunden ist, und daß

eine oder mehrere aktive Schaltungselemente der genannten Anzahl von aktiven Elementen der Eingangsstufe selektiv mit der Basis des ersten Transistors (Q$_5$) auf entsprechend verschiedene

Arten in den Eingangs- und Ausgangsschnittstellenschaltungen angeschlossen sind, um dadurch die entsprechend verschiedenen Schwellwertspannungen für Signale zu liefern, welche bei den entsprechenden Schaltungen ankommen.

2. Vorrichtung nach Anspruch 1, bei welcher die Zwischenverstärkerstufen (F$_2$) der Eingangs- und Ausgangsschnittstellenschaltungen (I$_i$, I$_o$) jeweils die ersten Transistoren (Q$_5$) mit ersten (R$_2$) und zweiten (R$_5$) Widerständen umfassen, die jeweils den Kollektor des ersten Transistors mit einer Energieversorgungsleitung (I$_1$) der Vorrichtung und den Emitter des ersten Transistors mit der Erdleitung (I$_2$) der Vorrichtung verbinden, und bei welcher die Eingangsstufen (F$_1$) der Eingangs- und Ausgangsschnittstellenschaltungen (I$_i$, I$_o$) jeweils einen Widerstand (R$_1$) umfassen, der mit der Energieversorgungsleitung (I$_1$) der Vorrichtung verbunden ist.

3. Vorrichtung nach Anspruch 1 oder 2, bei welcher die Schaltungselemente in jeder genannten Schnittstellenschaltung zu einer Verbindung fähig sind, um irgendeine der Vielzahl von verschiedenen solchen Schwellwertspannungen zu liefern, die jeweils geeignet sind für Signale, die von einer herkömmlichen TTL-Schaltung, einer Schottky-TTL-Schaltung, einer largescale-integrierten TTL-Schaltung außerhalb der Vorrichtung oder von einer large-scaleintegrierten funktionalen Schaltung der Vorrichtung kommen.

4. Vorrichtung nach Anspruch 1 oder 2, bei welcher jede der Eingangs- und Ausgangsschnittstellenschaltungen (I$_i$, I$_o$) in einem im allgemeinen L-förmigen Muster angeordnet ist und ein Bondkissen (BP) zwischen den Armen der L-förmigen Muster angeordnet ist.

5. Vorrichtung nach Anspruch 4, bei welcher in jeder der Eingangs- und Ausgangsschnittstellenschaltungen (I$_i$, I$_o$) die Eingangsstufe (F$_1$) im wesentlichen in einem Arm des L-förmigen Musters angeordnet, die Ausgangsstufe (F$_3$) im wesentlichen in dem anderen Arm des L-förmigen Musters und die Zwischenverstärkerstufe (F$_2$) im wesentlichen an der Verbindung der beiden Arme angeordnet ist.

6. Vorrichtung nach einem der vorhergehenden Ansprüche, bei welcher die Eingangsstufen (F$_1$) der Eingangs- und Ausgangsschnittstellenschaltungen (I$_i$, I$_o$) jeweils die folgenden Schaltungselemente umfassen:—

einen Widerstand (R$_1$), der mit einem Ende an einer Energieversorgungsleitung (I$_1$) der Vorrichtung angeschlossen ist,

eine erste Schottky-Diode (Q1), die mit einem Ende mit der Erdleitung (I$_2$) der Vorrichtung verbunden ist,

einen Schottky-Klammertransistor (Q4),

einen Transistor (Q3), dessen Kollektor mit der Erdleitung (I$_2$) der Vorrichtung verbunden ist, und

eine zweite Schottky-Diode (Q2), die mit einem Ende an der Basis des Transistors (Q3) angeschlossen ist;

wobei die Zwischenverstärkerstufen (F$_2$) der

Eingangs- und Ausgangsschnittstellenschalt-
ungen (I$_i$, I$_o$) jeweils die folgenden Schaltungs-
elemente umfassen:—

einen ersten Widerstand (R$_2$), der mit einem
Ende an der Energieversorgungsleitung (I$_1$) der
Vorrichtung angeschlossen ist,

einen Schottky-Klammertransistor (Q5), welcher
der genannte erste Transistor von Anspruch
1 ist und dessen Kollektor mit dem anderen
Ende des ersten Widerstands (R$_2$) der Zwi-
schenverstärkerstufe verbunden ist, und

einen zweiten Widerstand (R$_5$), der mit einem
Ende an dem Emitter des Schottky-Klammertransistors (Q5) der Zwischenverstärkerstufe und
mit seinem anderen Ende an der Erdleitung (I$_2$)
angeschlossen ist,

und bei welcher die Ausgangsstufen (F$_3$) der
Eingangs- und Ausgangsschnittstellen-
schlatungen (I$_i$, I$_o$) jeweils die folgenden Schalt-
ungselemente umfassen:—

einen ersten Widerstand (R$_4$), der mit einem
Ende an der Energieversorgungsleitung (I$_1$) ange-
schlossen ist,

einen zweiten Widerstand (R$_6$), der mit einem
Ende an der Erdleitung (I$_2$) angeschlossen ist,

einen dritten Widerstand (R$_3$), der mit einem
ende an der Energieversorgungsleitung (I$_1$) ange-
schlossen ist,

einen ersten Schottky-Klammertransistor (Q8),
dessen Kollektor mit dem anderen Ende des
dritten Widerstands der Ausgangsstufe verbunden ist,

einen Transistor (Q9), dessen Kollektor mit dem
anderen Ende des dritten Widerstands (R$_3$) der
Ausgangsstufe und dessen Basis mit dem Emitter
des ersten Schottky-Klammertransistors (Q8) der
Ausgangsstufe verbunden ist,

eine Schottky-Diode (Q7), deren eines Ende mit
dem anderen Ende des ersten Widerstands (R$_2$)
der Zwischenverstärkerstufe verbunden ist, und

einen zweiten Schottky-Klammertransistor
(Q6), welcher der genannte zweite Transistor des
Anspruchs 1 ist und dessen Basis mit dem einen
Ende des zweiten Widerstands (R$_5$) der
Zwischenverstärkerstufe und dessen Emitter mit
der Erdleitung (I$_2$) verbunden ist.

## Revendications

1. Circuit intégré à semi-conducteurs
comprenant une pastille semi-conductrice, avec
un circuit fonctionnel (FUN) disposée dans une
région centrale de la pastille et un circuit d'inter-
face d'entrée (Ii) pour transférer un signal émis
par un circuit extérieur au dispositif vers le circuit
fonctionnel (FUN) et un circuit d'interface de
sortie (I$_o$) pour transférer un signal émis par le
circuit fonctionnel (FUN) vers un circuit extérieur
au dispositif, le circuit d'interface d'entrée (I$_i$) et le
circuit d'interface de sortie (I$_o$) disposés dans une
région périphérique de la pastille comportant
chacun un étage d'entrée (F$_1$) et un étage de sortie
(F$_3$) pour un circuit d'interface, ces étages respec-
tifs (F$_1$, F$_3$) des circuits d'interface d'entrée et de
sortie remplissant des fonctions similaires et comprenant les uns et les autres le même type et
le même nombre d'éléments de circuits, les
éléments de circuits étant connectés sélectivement entre eux dans les étages pour former le
circuit d'interface d'entrée (I$_i$) ou le circuit d'inter-
face de sortie (I$_o$) selon les besoins et produisant
des tensions seuil différentes respectives pour
des signaux entrant dans ces circuits respectifs,
caractérisé en ce que le circuit d'interface d'entrée
(I$_i$) et le circuit d'interface de sortie (I$_o$) sont des
circuits logiques à transistor-transistor et comportent chacun en outre un étage d'amplification
intermédiaire (F$_2$) ces étages respectifs (F$_2$) des
circuits d'interface d'entrée et de sortie
comportant le même type et le même nombre
d'éléments de circuits les uns et les autres, en ce
que, dans chaque circuit d'interface, l'étage
d'entrée (F$_1$) comporte plusieurs éléments de
circuits actifs (Q$_1$ à Q$_4$) de types différentes,
l'étage d'amplification intermédiaire (F$_2$)
comportant un premier transistor (Q$_5$) et l'étage
de sortie (F$_3$) comportant un second transistor
(Q6) dont la base est connectée à l'émetteur du
premier transistor (Q5) et en ce que un ou
plusieurs éléments de circuits actifs desdits
plusieurs éléments actifs de l'étage d'entrée sont
connectés sélectivement à la base du premier
transistor (Q5) de manières différentes respectives dans les circuits d'interface d'entrée et de
sortie de manière à produire les tensions seuil
différentes respectives pour des signaux entrant
dans ces circuits respectifs.

2. Circuit selon la revendication 1, dans lequel
les étages d'amplification intermédiaire (F$_2$) des
circuits d'interface d'entrée et de sortie (I$_i$, I$_o$)
comportent chacun ledit premier transistor (Q5)
avec une première (R$_2$) et une seconde (R$_5$)
résistances respectivement connectant le collecteur du premier transistor à une ligne d'alimen-
tation (I$_1$) du dispositif et l'émetteur du premier
transistor à une ligne de masse (I$_2$) du dispositif,
et dans lequel les étages d'entrée (F$_1$) des circuits
d'interface d'entrée et de sortie (I$_i$, I$_o$) comportent
chacun une résistance (R$_1$) connectée à la ligne
d'alimentation (I$_1$) du dispositif.

3. Circuit selon la revendication 1 ou 2, dans
lequel les éléments de circuit de chacun desdits
circuits d'interface sont capables de connexions
pour établir l'une desdites plusieurs tensions
seuil différentes appropriées respectivement aux
signaux entrants provenant de circuits TTL
conventionnels, de circuits TTL Schottky, de
circuits TTL d'intégration poussée extérieurs aux
dispositifs et d'un circuit fonctionnel d'intégration
poussée du dispositif.

4. Circuit selon la revendication 1 ou 2, dans
lequel chacun desdits circuits d'interface d'entrée
et de sortie (I$_i$, I$_o$) est disposé en une forme
générale de L et une surface de connexion (BP)
est disposée entre les branches de la configuration en L.

5. Circuit selon la revendication 4, dans lequel
dans chacun des circuits d'interface d'entrée et de
sortie (I$_i$, I$_o$) l'étage d'entrée (F$_1$) est situé pratique-
ment dans un bras de la configuration en L, l'étage de sortie (F₃) est disposé pratiquement dans l'autre bras de la configuration en L et l'étage d'amplification intermédiaire (F₂) est disposé pratiquement à la jonction des deux branches.

6. Circuit selon l'une quelconque des revendications précédentes, dans lequel les étages d'entrée (F₁) des circuits d'interface d'entrée et de sortie (Iᵢ, I₀) comportent chacun les éléments de circuit suivants: une résistance (R₁) connectée par une extrémité à une ligne d'alimentation (I₁) du dispositif, une première diode de Schottky (Q₁) connectée par une extrémité à une ligne de masse (12) du dispositif, un transistor du type à barrière de Schottky (Q4), un transistor (Q3) dont le collecteur est connecté à la ligne de masse (12) du dispositif et une seconde diode de Schottky (Q2) connectée par une extrémité à la base du transistor (Q3); dans lequel les étages d'amplification intermédiaires (F₂) des circuits d'interface d'entrée et de sortie (Iᵢ, I₀) comportent chacun les éléments de circuits suivants: une première résistance (R₂) connectée par une extrémité à la ligne d'alimentation (I₁) du dispositif, un transistor du type à barrière de Schottky (Q5) étant ledit premier transistor de la revendication 1, dont le collecteur est connecté à l'autre extrémité de la première résistance (R₂) de l'étage d'amplification intermédiaire et une seconde résistance (R₅) connectée par une extrémité à !'émetteur du transistor du type à barrière de Schottky (Q5) de l'étage d'amplification intermédiaire et connectée à la ligne de masse (12) par son autre extrémité, et dans lequel les étages de sortie (F₃) des circuits d'interface d'entrée et de sortie (Iᵢ, I₀) comportent chacun les éléments de circuit suivants: une première résistance (R₄) connectée par une extrémité à la ligne d'alimentation (I₁), une seconde résistance (R₆) connectée par une extrémité à la ligne de masse (I₂), une troisième résistance (R₃) connectée par une extrémité à la ligne d'alimentation (I₁), un premier transistor du type à barrière de Schottky (Q8) dont le collecteur est connecté à l'autre extrémité de la troisième résistance (R₃) de l'étage de sortie, un transistor (Q9) dont le collecteur est connecté à l'autre extrémité de la troisième résistance (R₃) de l'étage de sortie et dont la base est connectée à l'émetteur du premier transistor du type à barrière de Schottky (Q8) de l'étage de sortie, une diode Schottky (Q7) connectée par une extrémité à l'autre extrémité de la première résistance (R₂) de l'étage d'amplification intermédiaire et un second transistor du type à barrière de Schottky (Q6), étant ledit second transistor de la revendication 1, dont la base est connectée à une extrémité de la seconde résistance (R₅) de l'étage d'amplification intermédiaire et dont l'émetteur est connecté à la ligne de masse (12).

FIG. I.

FIG. 2.

1

Fig. 3.

Fig. 4.

FIG. 5.

FIG. 6.

FROM OUTSIDE
A CHIP
(S–TTL)

FROM
INTERNAL
GATES

TO
INTERNAL
GATES

*Fig. 7.*

FROM
INTERNAL
GATES

FROM
OUTSIDE
A CHIP
(LS–TTL)

TO
INTERNAL
GATES

*Fig. 8.*

4

FROM OUTSIDE
A CHIP
(S-TTL)

FROM
INTERNAL
GATES

$R_1$ $R_2$ $R_3$ $R_4$

Q4 Q8 Q9

Q5 Q7

Q3

Q6

Q1 Q2

$R_5$ $R_6$

TO
OUTSIDE
A CHIP
(TTL)

FIG. 9.

FROM
INTERNAL
GATES

FROM
OUTSIDE
A CHIP
(LS-TTL)

$R_1$ $R_2$ $R_3$ $R_4$

Q4 Q8 Q9

Q5 Q7

Q3

Q6

Q1 Q2

$R_5$ $R_6$

TO
OUTSIDE
A CHIP
(TTL)

FIG. 10.

5

Fig. 11.

FROM OUTSIDE
A CHIP

TO
INTERNAL
GATES

Fig. 12.

TO OUTSIDE
A CHIP

FROM
INTERNAL
GATES

Fig. 13.

FROM
INTERNAL
GATES

TO
INTERNAL
GATES

*FIG.14.*

FROM
OUTSIDE
A CHIP

FROM
INTERNAL
GATES

TO
INTERNAL
GATES

*FIG.15.*

FROM
OUTSIDE
A CHIP

TO
OUTSIDE
A CHIP

FROM
INTERNAL
GATES

*Fig. 16.*

*Fig. 17.*